# EUROPÄISCHE PATENTSCHRIFT

(11) **EP 0 780 969 B1**
(45) Veröffentlichungstag und Bekanntmachung des Hinweises auf die Patenterteilung: **16.08.2001**
(21) Anmeldenummer: 96119300.0
(22) Anmeldetag: 02.12.1996
(51) Int. Cl.: H03D 9/06, G01S 7/03

(54) **Frequenzmischer für ein Dopplerradarmodul**
Frequency mixer for a Doppler radar module
Mélangeur de fréquence pour module de radar Doppler

(30) Priorität: 18.12.1995 DE 19547289
(43) Veröffentlichungstag der Anmeldung: 25.06.1997
(73) Patentinhaber: Infineon Technologies AG, 81669 München (DE)
(72) Erfinder: Lohninger, Gerhard, Dipl.-Ing., 81549 München (DE)
(74) Vertreter: Zedlitz, Peter, Dipl.-Inf.

(56) Entgegenhaltungen:
- EP-A- 0 050 393
- EP-A- 0 638 818
- US-A- 4 122 449
- US-A- 5 262 783

## Beschreibung

Die Erfindung bezieht sich auf einen Frequenzmischer für ein Dopplerradarmodul, bei dem eine erste Mikrostreifenleitung an einen ersten Anschluß einer ersten Diode und eine zweite Mikrostreifenleitung an einen ersten Anschluß einer zweiten Diode gekoppelt ist, die beiden Mikrostreifenleitungen über einen Kondensator miteinander gekoppelt sind und an die erste Mikrostreifenleitung eine Antenne gekoppelt ist. Außerdem ist an die beiden Mikrostreifenleitungen eine Schaltungsanordnung zur Bestimmung eines Phasenunterschiedes zwischen zwei Wechselspannungssignalen ankoppelbar.

Ein solcher Frequenzmischer ist beispielsweise aus der Patentschrift US 5,262,783 bekannt. Darin ist ein Bewegungsmelder mit Richtungserkennung beschrieben, der für eine Betriebsfrequenz von etwa 10 GHz ausgelegt ist und bei dem der Frequenzmischer eine erste und eine zweite Diode und eine erste und eine zweite Mikrostreifenleitung aufweist. Die beiden Mikrostreifenleitungen sind über einen Kondensator miteinander gekoppelt. Weiterhin ist die erste Mikrostreifenleitung an die Kathode der ersten Diode, die zweite Mikrostreifenleitung an die Anode der zweiten Diode und die Anode der ersten Diode an die Kathode der zweiten Diode angeschlossen.

Ein erster Hochfrequenz-Eingang dieses Frequenzmischers liegt in der Verbindungsleitung zwischen der Anode der ersten und der Kathode der zweiten Diode und ein zweiter Hochfrequenz-Eingang befindet sich auf der ersten Mikrostreifenleitung.

Beim Betrieb des oben beschriebenen Dopplerradarmoduls wird in den Frequenzmischer von einem an den ersten Hochfrequenz-Eingang gekoppelten Oszillator eine Hochfrequenz-Wechselspannung eingespeist, die gleichzeitig über eine ebenfalls an den Oszillator gekoppelte Sendeantenne in die Umgebung der Sendeantenne abgestrahlt wird.

An den zweiten Hochfrequenz-Eingang ist eine Empfangsantenne gekoppelt, die ggf. ein von einem sich im Sendebereich des Dopplerradarmoduls bewegenden Objekt reflektiertes Hochfrequenzsignal empfängt und in den Frequenzmischer einspeist. Im Frequenzmischer werden dann zwei Dopplerfrequenzen erzeugt, die zueinander eine Phasenverschiebung aufweisen. Über das Vorzeichen dieser Phasenverschiebung, die mittels eines an die beiden Mikrostreifenleitungen gekoppelten Phasenkomparator 20 ausgewertet wird, kann die Bewegungsrichtung des Objekts ermittelt werden.

Die Richtungserkennung bringt für manche Anwendungen von Dopplerradar-Bewegungsmeldern erhebliche Vorteile mit sich. Beispielsweise kann beim Einsatz in automatischen Türöffnern die Offenhaltedauer der Tür erheblich reduziert werden.

Ein Nachteil des oben beschriebenen Frequenzmischers ist jedoch, daß für seinen Betrieb zwei Antennen, und zwar eine separate Sende- und eine separate Empfangsantenne notwendig sind. Dies ist besonders bei Sende- und Empfangsfrequenzen unterhalb von 5 GHz mit einem hohen Platzaufwand verbunden, da Antennen für diese Frequenzen sehr großflächig sind.

Da jedoch die Frequenz von ca. 2,45 GHz eine weltweit fernmeldetechnisch zugelassene Betriebsfrequenz für Dopplerradarmodule ist, ist dieser Frequenzbereich von großer Bedeutung.

Der Erfindung liegt daher die Aufgabe zugrunde, einen Frequenzmischer der eingangs genannten Art zu entwickeln, der mit einer einzigen Antenne betrieben werden kann. Weiterhin soll dieser Frequenzmischer für den Betrieb bei Frequenzen von weniger als 5 GHz geeignet, möglichst klein und einfach herstellbar sein.

Diese Aufgabe wird durch einen Frequenzmischer der eingangs genannten Art gelöst, der dadurch gekennzeichnet ist, daß ein zweiter Anschluß der ersten Diode und ein zweiter Anschluß der zweiten Diode jeweils mit einem festen Potential elektrisch leitend verbunden ist und daß an die zweite Mikrostreifenleitung ein Oszillator angekoppelt ist.

Vorteilhafte Ausgestaltungen und Weiterbildungen der Erfindung sind Gegenstand von Unteransprüchen.

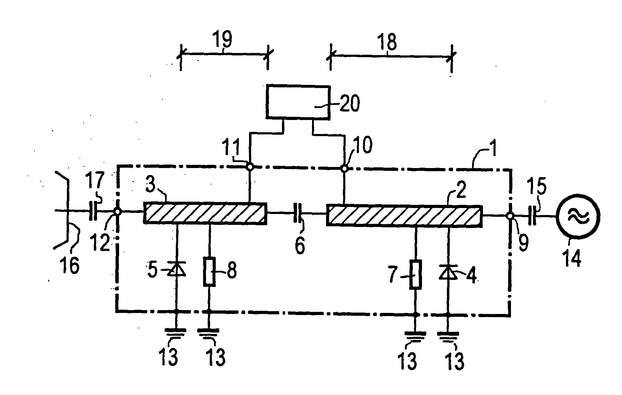

Die Erfindung wird anhand eines Ausführungsbeispieles in Verbindung mit der Figur 1 näher erläutert. Die Figur 1 zeigt eine schematische Darstellung des Ausführungsbeispieles.

Bei der in Figur 1 schematisch dargestellten Schaltungsanordnung sind die zum Frequenzmischer gehörenden Bauelemente innerhalb der gestrichelten Linie 1 angeordnet. Demzufolge weist dieser Frequenzmischer zwei Mikrostreifenleitungen 2, 3, zwei Dioden 4, 5, einen Kondensator 6, zwei Widerstände 7, 8 und vier Anschlüsse 9, 10, 11, 12 auf. Die Kathode der Diode 4 und die Kathode der Diode 5 ist mit der Mikrostreifenleitung 2 bzw. mit der Mikrostreifenleitung 3 verbunden. Die Anoden der beiden Dioden 4, 5 liegen auf Masse 13 und die Widerstände 7 und 8 sind zwischen der Mikrostreifenleitung 2 und Masse 13 bzw. zwischen der Mikrostreifenleitung 3 und Masse 13 angeschlossen angeschlossen. Die beiden Mikrostreifenleitungen 2, 3 sind über den Kondensator 6, der einerseits an die Mikrostreifenleitung 2 und andererseits an die Mikrostreifenleitung 3 angeschlossen ist, miteinander gekoppelt. Außerdem ist die Mikrostreifenleitung 2 mit den Anschlüssen 9 und 10 und die Mikrostreifenleitung 3 mit den Anschlüssen 11 und 12 verbunden.

Dieses Ausführungsbeispiel des erfindungsgemäßen Frequenzmischers wird von einem Oszillator 14, der über einen Kondensator 15 an den Anschluß 9 gekoppelt ist, mit einem Hochfrequenzsignal versorgt. Dieses Hochfrequenzsignal wird über eine Antenne 16, die über einen Kondensator 17 an den Anschluß 12 gekoppelt ist, in die Umgebung der Antenne abgestrahlt.

An den beiden Dioden 4 und 5 liegen zueinander phasenverschobene Hochfrequenzsignale an. Die Phasenverschiebung zwischen diesen beiden Hochfrequenzsignalen kann über den Kondensator 6 und die Leitungslängen 18 und 19 der Mikrostreifenleitungen 2 bzw. 3 definiert eingestellt werden.

Ein ggf. von einem sich in der Umgebung der Antenne 16 bewegenden Objekts reflektiertes Hochfrequenzsignal wird von der Antenne 16 empfangen und über den Kondensator 17 und den Anschluß 12 in den Frequenzmischer eingekoppelt. An den beiden Dioden 4, 5 werden folglich zwei zueinander phasenverschobene Dopplersignale gleicher Frequenz erzeugt, die von einem an die Anschlüsse 10 und 11 angeschlossenen Phasenkomparator 20 ausgewertet werden. Das Vorzeichen der Phasenverschiebung zwischen den beiden Dopplerfrequenzen gibt Aufschluß über die Bewegungsrichtung des Objekts.

Die Widerstände 7 und 8 sind Selfbiasing-Elemente für die Dioden 4 und 5 und verbessern die Frequenzumsetzung. Die Kondensatoren 15 und 17 dienen zur DC-Entkopplung des Frequenzmischers gegenüber dem Oszillators 14 bzw. der Antenne 16 und bilden für die Hochfrequenzen einen verlustarmen Übergang.

Anstelle der Widerstände 7 und 8 kann zum Anlegen einer Vorspannung an die Dioden 4 und 5 auch von extern an die Dioden 4, 5 eine Gleichspannung angelegt sein. Die dazu verwendete Gleichspannungsquelle ist hierbei notwendigerweise hochfrequenzmäßig vom Frequenzmischer entkoppelt.

Ebenso ist es möglich, bei dem oben beschriebenen Frequenzmischer die Anoden der Dioden 4 und 5 nicht auf Masse, sondern auf ein beliebiges anderes festes Potential zu legen. Dabei müssen die festen Potentiale nicht zwangsweise identisch sein.

Ein Vorteil des oben beschriebenen Frequenzenmischers besteht unter anderem darin, daß die Dopplersignalpegel an den Dioden 4 und 5 mittels Anpassung der Kapazität des Kondensators 6 und mittels Verändern des Verhältnisses der beiden Leitungslängen 18 und 19 der Mikrostreifenleitungen 2 und 3 auf einfache Weise eingestellt werden können.

Weiterhin ist von Vorteil, daß der erfindungsgemäße Frequenzmischer auf einfache Weise zusammen mit dem Oszillator 14 und den Kondensatoren 15 und 17 gemeinsam platzsparend auf einer einzigen Ebene einer Multilayerplatine eines Dopplerradarmoduls angeordnet werden können. Die Antenne 16, eine Sende- und Empfangsantenne, kann auf einer zweiten Ebene der Multilayerplatine oder auch auf einer separaten Platine angeordnet sein.

Um eine geringe Oberflächenabstrahlung des Dopplerradarmoduls zu erzielen, kann auf einer weiteren Ebene der Multilayerplatine oder auf einer weiteren Platine eine Mehrzahl von Triplate-Filterstrukturen angeordnet sein, die mit dem Frequenzmischer verschaltet sind. Hierbei ist in die Anschlußleitung zwischen der Antenne 16 und dem Frequenzmischer eine HF-Filterstruktur und sind in die Anschlußleitungen zwischen den Mikrostreifenleitungen 2 und 3 und dem Phasenkomparator 20 NF-Filterstrukturen gekoppelt.

## Patentansprüche

1. Frequenzmischer für ein Dopplerradarmodul mit den Merkmalen:
a) eine erste Mikrostreifenleitung (3) ist an einen ersten Anschluß einer ersten Diode (5) und eine zweite Mikrostreifenleitung (2) ist an einen ersten Anschluß einer zweiten Diode (4) gekoppelt,
b) die beiden Mikrostreifenleitungen (2,3) sind über einen Kondensator (6) miteinander gekoppelt,
c) an die erste Mikrostreifenleitung (3) ist eine Antenne (16) gekoppelt,
d) an die beiden Mikrostreifenleitungen (2, 3) ist eine Schaltungsanordnung (20) zur Bestimmung eines Phasenunterschieds zwischen zwei Wechselspannungssignalen ankoppelbar, **dadurch gekennzeichnet**, daß
e) ein zweiter Anschluß der ersten Diode (5) und ein zweiter Anschluß der zweiten Diode (4) jeweils mit einem festen Potential (13) elektrisch leitend verbunden ist und daß
f) an die zweite Mikrostreifenleitung (2) ein Oszillator (14) gekoppelt ist.

2. Frequenzmischer nach Anspruch 1, **dadurch gekennzeichnet**, daß die Dioden (4, 5) mit ein und demselben festen Potential (13) elektrisch leitend verbunden sind.

3. Frequenzmischer nach Anspruch 1 oder 2, **dadurch gekennzeichnet**, daß das feste Potential (13) Massepotential ist.

4. Frequenzmischer nach einem der Ansprüche 1 bis 3, **dadurch gekennzeichnet**, daß zwischen den beiden Mikrostreifenleitungen (2, 3) und dem festen Potential (13) jeweils ein Widerstand angeschlossen ist.

5. Frequenzmischer nach einem der Ansprüche 1 bis 4, **dadurch gekennzeichnet**, daß er zusammen mit der Antenne (16) und dem Oszillator (14) auf einer einzigen Multilayerplatine angeordnet ist.

6. Frequenzmischer nach einem der Ansprüche 1 bis 5, **dadurch gekennzeichnet**, daß er zusammen mit dem Oszillator (14) auf einer einzigen Ebene einer bzw. der Mulitlayerplatine angeordnet ist.

7. Frequenzmischer nach einem der Ansprüche 1 bis 6, **dadurch gekennzeichnet**,daß die Antenne (16) auf einer zweiten Ebene einer bzw. der Mulitlayerplatine angeordnet ist.

## Claims

1. Frequency mixer for a Doppler radar module having the following features:
a) a first microstrip line (3) is coupled to a first connection of a first diode (5), and a second microstrip line (2) is coupled to a first connection of a second diode (4),
b) the two microstrip lines (2, 3) are coupled to one another via a capacitor (6),
c) an antenna (16) is coupled to the first microstrip line (3),
d) a circuit arrangement (20) for determining any phase difference between two AC voltage signals can be coupled to the two microstrip lines (2, 3),
characterized in that
e) a second connection of the first diode (5) and a second connection of the second diode (4) are each electrically conductively connected to a fixed potential (13), and in that
f) an oscillator (14) is coupled to the second microstrip line (2).

2. Frequency mixer according to Claim 1, characterized in that the diodes (4, 5) are electrically conductively connected to one and the same fixed potential (13).

3. Frequency mixer according to Claim 1 or 2, characterized in that the fixed potential (13) is earth potential.

4. Frequency mixer according to one of Claims 1 to 3, characterized in that a resistor is connected between each of the two microstrip lines (2, 3) and the fixed potential (13).

5. Frequency mixer according to one of Claims 1 to 4, characterized in that the frequency mixer is arranged together with the antenna (16) and the oscillator (14) on a single multilayer board.

6. Frequency mixer according to one of Claims 1 to 5, characterized in that the frequency mixer is arranged together with the oscillator (14) on a single layer of a or the multilayer board.

7. Frequency mixer according to one of Claims 1 to 6, characterized in that the antenna (16) is arranged on a second layer of a or the multilayer board.

## Revendications

1. Mélangeur de fréquence pour un module radar Doppler ayant les caractéristiques :
a) une première microligne (3) à ruban est couplée à une première borne d'une première diode (5) et une deuxième microligne (2) à ruban est couplée à une première borne d'une deuxième diode (4),
b) les deux microlignes (2, 3) à ruban sont couplées entre elles par un condensateur (6),
c) sur la première microligne (3) à ruban est couplée une antenne (16),
d) sur les deux microlignes (2, 3) à ruban peut être couplé un circuit (20) de détermination d'une différence de phase entre deux signaux en tension alternative,
caractérisé en ce que
e) une deuxième borne de la première diode (5) et une deuxième borne de la deuxième diode (4) sont reliées d'une manière conductrice de l'électricité respectivement à un potentiel (13) fixe et en ce que
f) à la deuxième microligne (2) à ruban est couplé un oscillateur (14).

2. Mélangeur de fréquence suivant la revendication 1, caractérisé en ce que les diodes (4, 5) sont reliées de manière conductrice de l'électricité à un seul et même potentiel (13) fixe.

3. Mélangeur de fréquence suivant la revendication 1 ou 2, caractérisé en ce que le potentiel (13) fixe est le potentiel de masse.

4. Mélangeur de fréquence suivant l'une des revendications 1 à 3, caractérisé en ce qu'il est raccordé entre les deux microlignes (2, 3) à ruban et le potentiel (13) fixe respectivement une résistance.

5. Mélangeur de fréquence suivant l'une des revendications 1 à 4, caractérisé en ce qu'il est monté, ensemble avec l'antenne (7) et l'oscillateur (14), sur une platine multicouche unique.

6. Mélangeur de fréquence suivant l'une des revendications 1 à 5, caractérisé en ce qu'il est monté, ensemble avec l'oscillateur (14), sur un plan unique d'une platine multicouche ou de la platine multicouche.

7. Mélangeur de fréquence suivant l'une des revendicatio8ns 1 à 6, caractérisé en ce que l'antenne (7) est montée sur un deuxième plan d'une platine multicouche ou de la platine multicouche.
